Europäisches Patentamt

European Patent Office

Office européen des brevets

(19)

(11) Numéro de publication : **0 384 863 B1**

(12) **FASCICULE DE BREVET EUROPEEN**

(45) Date de publication du fascicule du brevet :
18.05.94 Bulletin 94/20

(21) Numéro de dépôt : **90420089.6**

(22) Date de dépôt : **21.02.90**

(51) Int. Cl.⁵ : **H03K 19/013**

(54) **Circuit de sortie compatible TTL à vitesse de commutation élevée.**

(30) Priorité : **24.02.89 FR 8902859**

(43) Date de publication de la demande :
**29.08.90 Bulletin 90/35**

(45) Mention de la délivrance du brevet :
**18.05.94 Bulletin 94/20**

(84) Etats contractants désignés :
**DE FR GB IT NL**

(56) Documents cités :
**PATENT ABSTRACTS OF JAPAN, vol. 10, no.
268 (E-436)[2324], 12 septembre 1986 &
JP-A-61-90 518
PATENT ABSTRACTS OF JAPAN, vol. 4, no. 97
(E-18)[579], 12 juillet 1980, page 77 K 12 &
JP-A-55-60 339
PATENT ABSTRACTS OF JAPAN, vol. 11, no.
65 (E-484)[2512], 27 février 1987 & JP-A-61-224
727**

(56) Documents cités :
**PATENT ABSTRACTS OF JAPAN, vol. 4, no.
141 (E-28)[623], 4 octobre 1980, page 52 E 28 &
JP-A-55-92 038
PATENT ABSTRACTS OF JAPAN, vol. 12, no.
385 (E-668)[3232], 14 octobre 1988 & JP-A-
63-128 814
PATENT ABSTRACTS OF JAPAN, vol. 11, no.
161 (E-509)[2608], 23 mai 1987 & JP-A-61-293
022**

(73) Titulaire : **SGS-THOMSON
MICROELECTRONICS S.A.
7, Avenue Galliéni
F-94250 Gentilly (FR)**

(72) Inventeur : **Mouret, Michel
Les Thévenets, Hauts de Jarry
F-38560 Jarry (FR)**

(74) Mandataire : **de Beaumont, Michel
1bis, rue Champollion
F-38000 Grenoble (FR)**

EP 0 384 863 B1

Jouve, 18, rue Saint-Denis, 75001 PARIS

## Description

La présente invention concerne des circuits de sortie bipolaires compatibles avec des circuits du type TTL, et plus particulièrement des circuits de sortie à vitesse de commutation élevée sans dispositifs Schottky (ces derniers n'étant pas réalisables dans certaines filières technologiques).

Les circuits de sortie compatibles TTL concernés doivent fournir soit des signaux de tension supérieure à 2,4 V, soit des signaux de tension inférieure à 0,4 V. Dans le dernier cas, le circuit de sortie doit pouvoir supporter un courant de l'ordre de 16 à 24 mA reçu sur sa borne de sortie.

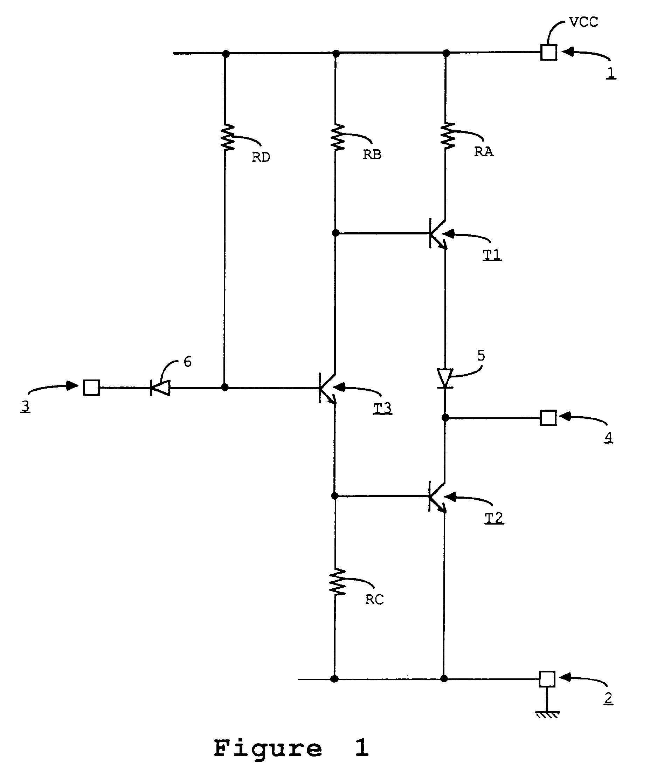

La figure 1 représente un circuit de sortie bipolaire classique. Il est alimenté par une source d'alimentation dont une première borne 1 délivre une tension VCC positive et dont la deuxième borne 2 est reliée à la masse. Il comprend une borne d'entrée 3 et une borne de sortie 4. Un premier transistor de sortie NPN T1 a son collecteur relié à la borne 1 par l'intermédiaire d'une résistance RA et son émetteur relié à la borne de sortie par l'intermédiaire d'une diode 5. Un deuxième transistor de sortie NPN T2 a son collecteur connecté à la borne de sortie et son émetteur relié à la borne 2 de la source d'alimentation. Le collecteur d'un transistor de commande NPN T3 est d'une part relié à la base du transistor T1 et est d'autre part relié, par l'intermédiaire d'une résistance RB, à la borne 1 de la source d'alimentation. L'émetteur de ce transistor T3 est connecté à la base du transistor T2 et est relié, par l'intermédiaire d'une résistance RC, à la borne 2 de la source d'alimentation. Le transistor T3 a sa base reliée d'une part à la borne 1 par l'intermédiaire d'une résistance RD et d'autre part à la borne d'entrée 3 par l'intermédiaire d'une diode 6.

Deux niveaux de tension peuvent être appliqués sur la borne d'entrée : un niveau de tension bas (état bas) et un niveau de tension haut (état haut). Quand l'entrée est à l'état bas, la diode 6 est polarisée en direct. Le transistor T3, ainsi que le transistor T2, sont bloqués. Le transistor T1 est passant et la sortie est à l'état haut. Lorsque l'entrée est à l'état haut, les transistors T3 et T2 sont passants et le transistor T1 est bloqué. La sortie est à l'état bas.

Le circuit de la figure 1 fonctionne de façon satisfaisante si les transistors et diodes représentés sont de type Schottky. La vitesse de commutation est alors très élevée (de l'ordre de quelques nanosecondes). Toutefois si, comme cela est illustré, les transistors et diodes sont de type bipolaire classique, deux phénomènes viennent limiter la vitesse de commutation.

D'une part, si dans le circuit certains transistors fonctionnent en régime de saturation, leur vitesse de commutation à l'ouverture est réduite.

D'autre part, lors de la commutation à la fermeture d'un transistor, la vitesse de commutation est réduite par suite de l'effet Miller.

Lorsqu' un transistor est à l'état de saturation, le fait que le courant iB dans la base soit relativement important, la tension de base étant supérieure à la tension de collecteur, entraîne un stockage de charges dans la base du transistor (si on appelle IC le courant dans le collecteur et g le gain du transistor, on a en régime de saturation IC/iB << g ). Ainsi, pour éviter ce régime de saturation, on limite le courant dans la base lorsque le transistor est passant, ou on fait en sorte que la chute de tension entre la base et le collecteur soit strictement inférieure à une tension seuil VS qui est en pratique de l'ordre de la tension VBE existant entre la base et l'émetteur d'un transistor à l'état passant.

Pour limiter l'effet Miller à la fermeture, on limitera le gain en tension des transistors pour lesquels la charge de la capacité base-collecteur, cette charge s'effectuant par le courant arrivant sur la base, est critique.

Dans le circuit de la figure 1, lorsque la sortie 4 est à l'état bas, chacun des deux transistors T2 et T3 présente une chute de tension entre collecteur et émetteur faible. La différence de tension entre base et collecteur est sensiblement égale à la chute de tension VBE entre base et émetteur, qui est classiquement de l'ordre de 0,7 V. La chute de tension entre base et collecteur est de l'ordre de la tension seuil VS. Les transistors T2 et T3 fonctionnent en régime de saturation.

En outre, la charge de la capacité base-collecteur du transistor T3 à la fermeture est lente en raison de la présence de la résistance RD. En outre, le gain en tension du transistor T3 est important en raison de la présence de la résistance RB. Le transistor T3 présente donc un effet Miller important à la fermeture.

Dans l'art antérieur, pour résoudre ce problème, on a essayé de prévoir des circuits de sortie sans dispositifs Schottky à commutation rapide. Pour cela, on s'est essentiellement attaché à éviter le fonctionnement en régime de saturation du transistor de sortie de mise à l'état bas (T2). Ceci permet une première amélioration. Toutefois, quand on considère tous les circuits connus, on s'aperçoit qu'ils comprennent tous, dans les étages de commande, des transistors fonctionnant en régime de saturation lorsqu'ils sont à l'état passant ou des transistors à gains en tension importants, pour lesquels la charge de la capacité base-collecteur est critique et qui présentent donc un effet Miller notable [voir par exemple JP-A-61-90518 et Patent Abstracts of Japan, volume 10, no. 268 (E-436) [2234], 12 septembre 1986, dans lequel le transistor Tr3 présente un effet Miller important].

Un objet de la présente invention est de prévoir un circuit de sortie compatible TTL à vitesse de commutation élevée.

Pour atteindre cet objet, la présente invention prévoit un circuit dans lequel aucun transistor ne fonctionne en régime de saturation et ne présente d'effet Miller important.

Plus précisément, la présente invention prévoit un circuit de sortie compatible avec des circuits du type TTL, ayant une borne de sortie et une borne d'entrée, réalisé sans dispositifs Schottky, et comprenant un étage intermédiaire et un étage de sortie reliés à une source d'alimentation dont la première borne délivre une tension supérieure à celle de sa deuxième borne. L'étage de sortie comprend:

- un premier transistor dont le collecteur et la base sont reliés à la première borne de la source d'alimentation par l'intermédiaire d'une première résistance et d'une deuxième résistance, respectivement,
- une première diode dont l'anode est reliée à l'émetteur du premier transistor et dont la cathode est reliée à la borne de sortie,
- un deuxième transistor dont le collecteur est relié à la borne de sortie, dont l'émetteur est connecté à la deuxième borne de la source d'alimentation et dont la base est reliée à une troisième résistance dont la borne libre est connectée à la deuxième borne de la source d'alimentation,
- un troisième transistor dont l'émetteur est connecté à la base du deuxième transistor par l'intermédiaire d'une quatrième résistance, dont le collecteur est connecté à la première borne de la source d'alimentation et dont la base est reliée à la borne d'entrée,
- une deuxième diode dont l'anode est reliée à la borne d'entrée et dont la cathode est connectée à l'émetteur du premier transistor.

L'étage intermédiaire est constitué par un inverseur qui commande le premier transistor en opposition de phase par rapport à la commande du deuxième transistor.

L'inverseur comprend :

- un quatrième transistor dont le collecteur est connecté à la première borne de la source d'alimentation, dont l'émetteur est relié par l'intermédiaire d'une cinquième résistance à la deuxième borne de la source d'alimentation et dont la base est reliée à la borne d'entrée,
- un cinquième transistor dont la base est connectée à l'émetteur du quatrième transistor, dont l'émetteur est connecté à la deuxième borne de la source d'alimentation et dont le collecteur est connecté à la base du premier transistor, et
- une troisième diode dont l'anode est reliée à la borne d'entrée et dont la cathode est connectée au collecteur du cinquième transistor.

Ces objets, caractéristiques et avantages ainsi que d'autres de la présente invention seront exposés plus en détail dans la description suivante d'un mode de réalisation particulier faite en relation avec les figures jointes parmi lesquelles :

la figure 1, déjà décrite, représente un circuit de sortie classique;

la figure 2 représente un circuit de sortie selon la présente invention; et

la figure 3 représente une partie du circuit de sortie de la figure 2.

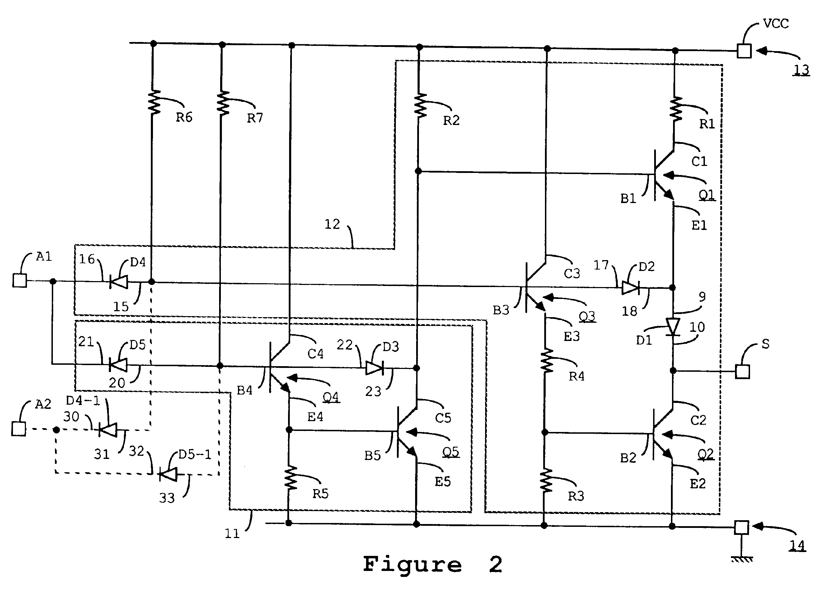

La figure 2 représente un circuit bipolaire de sortie compatible TTL à vitesse de commutation élevée selon la présente invention. Ce circuit comprend un étage intermédiaire 11 et un étage de sortie 12 reliés à une source d'alimentation dont la première borne 13 délivre une tension positive VCC et dont la deuxième borne 14 est connectée à la masse. Le circuit possède aussi une borne d'entrée A1 et une borne de sortie S.

L'étage de sortie comprend un premier transistor Q1 dont le collecteur C1 et la base B1 sont reliés à la borne 13 de la source d'alimentation par l'intermédiaire d'une première résistance R1 et d'une deuxième résistance R2, respectivement. L'émetteur E1 du transistor Q1 est relié à l'anode 9 d'une diode D1 dont la cathode 10 est reliée au collecteur C2 d'un deuxième transistor Q2 et à la borne de sortie S du circuit. Le transistor Q2 a son émetteur E2 connecté à la masse et sa base B2 reliée d'une part, par l'intermédiaire d'une résistance R3, à la masse et d'autre part, par l'intermédiaire d'une résistance R4, à l'émetteur E3 d'un troisième transistor Q3 dont le collecteur C3 est connecté à la borne 13 de la source d'alimentation. La base B3 du transistor Q3 est reliée d'une part à l'anode 15 d'une diode D4 dont la cathode 16 est connectée à la borne d'entrée A1 et d'autre part à l'anode 17 d'une diode D2 dont la cathode 18 est connectée à l'émetteur E1 du transistor Q1.

L'étage intermédiaire 11 est constitué par un inverseur qui comprend un transistor Q4 dont le collecteur C4 est connecté à la borne 13 de la source d'alimentation et dont l'émetteur E4 est relié par l'intermédiaire d'une résistance R5 à la masse. La base B4 du transistor Q4 est connectée d'une part à l'anode 20 d'une diode D5 dont la cathode 21 est reliée à la borne d'entrée A1 et d'autre part à l'anode 22 d'une diode D3 dont la cathode 23 est connectée au collecteur C5 d'un transistor Q5. Ce transistor Q5 a sa base B5 connectée à l'émetteur E4 du transistor Q4 et son émetteur ES connecté à la masse.

Une résistance R6 est connectée entre la borne 13 de la source d'alimentation et l'anode 15 de la diode D4. Une résistance R7 est connectée entre la borne 13 de la source d'alimentation et l'anode 20 de la diode D5.

## Fonctionnement du circuit quand l'entrée est à l'état bas

Quand l'entrée A1 est à l'état bas, la diode D4 est polarisée en direct. La tension sur la base B3 du transistor Q3 est basse, et ce transistor est bloqué. La tension sur la base B2 du transistor Q2 est alors également basse, et ce transistor Q2 est aussi bloqué. De plus, la diode D5 est polarisée en direct, et les transistors Q4 et Q5 sont bloqués. Du fait de l'état bloqué du transistor Q5, la diode D3 étant polarisée en inverse, la tension sur la base du transistor Q1 est haute, et ce transistor Q1 est passant. La diode D2 est polarisée en inverse et la diode D1 en direct. La sortie S est à l'état haut.

Le courant sortant par la sortie S lorsque celle-ci est à l'état haut est faible, il vaut 400 μA par exemple au maximum. La résistance R1 est ainsi également très faible, elle a par exemple une valeur de 50 ohms. La chute de tension à ses bornes est alors de 20 mV. Si le transistor a un gain de 100, il passe dans la résistance R2 un courant de 4 μA. Dans le cas où R2 a une valeur de 1000 ohms, la chute de tension à ses bornes est de 4 mV. La chute de tension entre la base et le collecteur du transistor Q1 est égale à 16 mV, ce qui est bien trop faible pour entraîner un fonctionnement en régime de saturation de ce transistor Q1.

Les résistances R6 et R7 sont des résistances importantes valant quelques dizaines de kiloohms pour notamment limiter la consommation de ce circuit de sortie et le courant de charge du circuit de commande relié à l'entrée A1. La charge des capacités base-collecteur des transistors Q3 et Q4 se fait par l'intermédiaire des résistances R6 et R7, respectivement. Les courants de charge des capacités sont peu importants et la charge des capacités est critique pour ces deux transistors. Dans ce circuit, aucune charge n'est connectée à leurs collecteurs. Leurs gains en tension sont ainsi nuls et ils ne présentent pas d'effet Miller à la fermeture, c'est-à-dire lorsque l'entrée A1 passe de l'état bas à l'état haut.

Le transistor Q5 a sa base reliée à l'émetteur du transistor Q4. Le transistor Q4 présente vis-à-vis du transistor Q5 une faible impédance de sortie. De plus, lorsque le transistor Q4 est mis en conduction, il est parcouru par un courant élevé en régime transitoire avant de se stabiliser à une valeur beaucoup moins importante en régime d'équilibre (c'est-à-dire une fois que le transistor Q5 et la diode D3 auront été établis en régime de conduction permanent). Le courant de charge de la capacité base-collecteur du transistor Q5 lors de sa mise en conduction est donc très important et la charge de la capacité n'est pas critique. En outre, le transistor Q5 a son collecteur relié à la résistance R2 qui est peu élevée, avec une valeur de l'ordre de quelques milliers d'ohms. Ce transistor Q5 ne présente pas d'effet Miller important à la fermeture.

Le transistor Q2 a sa base reliée à l'émetteur du transistor Q3 par l'intermédiaire de la résistance R4. Cette résistance est de l'ordre de quelques centaines d'ohms. Le transistor Q3 a une faible impédance de sortie. A sa mise en conduction, il est parcouru par un courant important en régime transitoire. Le courant de charge de la capacité base-collecteur du transistor Q2 est élevé et la charge de la capacité n'est pas critique. En outre, ce transistor reçoit lorsque la sortie est à l'état bas des courants de l'ordre de 20 mA qui sont assez élevés, et cela correspond à une charge assez faible sur le collecteur. Le transistor Q2 ne présente pas d'effet Miller important à la fermeture.

## Fonctionnement du circuit quand l'entrée est à l'état haut

Quand l'entrée A1 est à l'état haut, la diode D5 est polarisée en inverse. La tension sur la base du transistor Q4 est haute et ce transistor est passant. La tension sur la base du transistor Q5 est ainsi également haute et le transistor Q5 est passant. En outre, la diode D3 est polarisée en direct et le transistor Q1 est bloqué.

Si l'on admet que tous les transistors, lorsqu'ils sont à l'état passant, présentent une même chute de tension VBE entre la base et l'émetteur, et si l'on approxime la chute de tension aux bornes des diodes du circuit polarisées en direct à la chute de tension VBE, la tension sur la base du transistor Q5 est égale à VBE, et la tension sur la base du transistor Q4 est 2VBE. La tension sur la cathode 23 de la diode D3, c'est-à-dire sur le collecteur C5 du transistor Q5, est de l'ordre de VBE.

Le transistor Q2 étant passant, la tension sur sa base B2 est égale à VBE. Il passe un courant IE3 dans la résistance R4, la tension sur l'émetteur E3 du transistor Q3 est égale à VBE+R4xIE3. La tension sur la base du transistor Q3 est alors 2VBE+R4xIE3. La tension sur la cathode 18 de la diode D2 est égale à VBE+R4xIE3. La tension sur le collecteur C2 du transistor Q2 est ainsi de l'ordre de R4xIE3. Les valeurs de R3 et R4 sont telles que la tension sur le collecteur du transistor Q2, c'est-à-dire sur la sortie 5, soit égale à quelques centaines de millivolts, par exemple 300 mV.

Cette tension est suffisante pour que le transistor Q2 ne fonctionne pas en régime de saturation. En effet, la chute de tension entre la base et le collecteur est alors de l'ordre de 700-300 = 400 mV, ce qui est inférieur à la tension seuil $V_S$.

On vient de voir que la tension sur la base du transistor Q3 lorsqu'il est passant est 2VBE+R4xIE3. La valeur de la résistance R4 est de quelques centaines d'ohms, par exemple 300 ohms, et le courant IE3 est de l'ordre de 1 mA. La tension de base du transistor Q3 vaut ainsi environ 1,7 V. La tension sur le collecteur du transistor Q3, qui est la tension d'alimentation VCC égale par exemple à 5 V, est bien supérieure à la tension sur la base et le transistor Q3 ne fonctionne pas en régime de saturation.

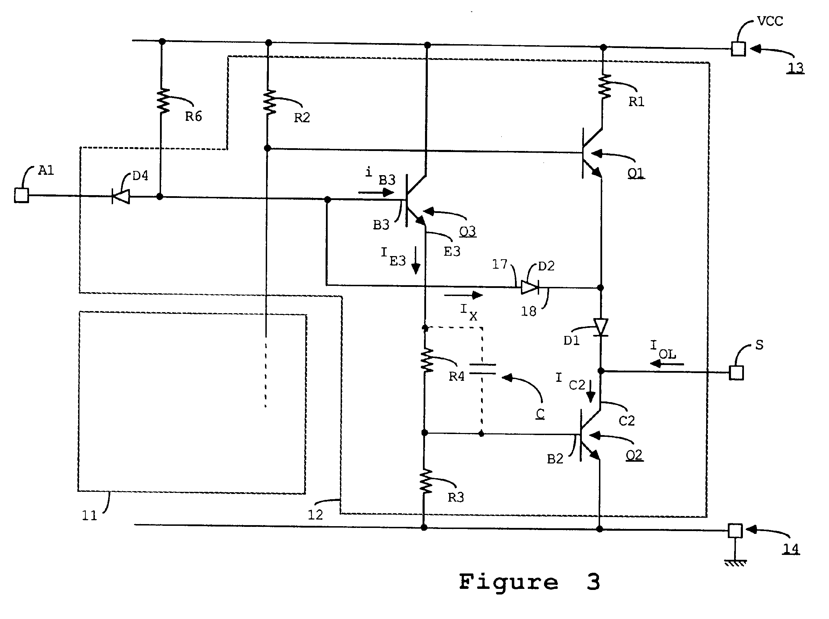

La figure 3 représente l'étage de sortie 12 de la figure 2 dessiné différemment, par rapport à la figure 2, au niveau de la connexion entre l'anode 17 de la diode D2 et la base B3 du transistor Q3. L'étage de sortie est le même dans les figures 2 et 3, mais le dessin dans la figure 3 permet une meilleure compréhension de son fonctionnement lorsque l'entrée A1 est à l'état haut.

Ainsi, quand l'entrée A1 est à l'état haut, la diode D4 est polarisée en inverse. Le transistor Q3 est passant. Les diodes D2 et D1 sont polarisées en direct. Le courant iB3 dans la base du transistor Q3 s'ajuste en fonction de l'intensité du courant IOL reçu sur la sortie S. En effet, la relation entre les courants iB3 et IOL s'établit de la façon suivante. Si l'on appelle IE3 le courant dans l'émetteur du transistor Q3 et g3 le gain de ce transistor Q3, le courant iB3 est donné par iB3 = IE3/(g3+I). Par ailleurs, si iB2 est le courant dans la base du transistor Q2, le courant IE3 est donné par IE3 = iB2+VBE/R3. On a donc la relation suivante :

$$iB3 = [iB2/(g3 + I)] + [VBE/R3(g3 + I)] \quad (1)$$

Le courant IC2 dans le collecteur du transistor Q2 est la somme du courant IOL et d'un courant IX traversant la diode D1. Si l'on appelle g2 le gain du transistor, on a :

$$iB2 = (IX + IOL)/g2$$

Puisque le transistor Q1 est bloqué, la diode D2 est également traversée par le courant IX. Comme la base du transistor Q3 est reliée à la borne 13 de la source d'alimentation par l'intermédiaire de la résistance R6 et que la diode D4 est polarisée en inverse, la somme I = iB3+IX est constante. Le courant iB2 est ainsi donné par:

$$iB2 = (I - iB3 + IOL)/g2$$

Le courant dans la base du transistor Q3 s'écrit donc :

$$iB3 = I/g2(g3 + I) - iB3/g2(g3 + I) + IOL/g2(g3 + I) + VBE/(g3 + I)R3$$

On a ainsi :

$$iB3[I + I/g2(g3 + I)] = IOL/g2(g3 + I) + Ig2(g3 + I) + VBE/(g3 + I)R3$$

Les courants iB3 et IOL sont donc reliés par une relation du type iB3 = MIOL+P où M et P sont des constantes. Puisque M est une constante positive, lorsque le courant IOL reçu sur la sortie S augmente, le courant iB3 augmente aussi. D'après la relation (1), le courant iB2 augmente. Il apparaît ainsi une augmentation du courant IC2 ce qui permet d'absorber l'accroissement du courant IOL.

Il a été vu précédemment que la tension de base du transistor Q4 lorsqu'il est passant est 2VBE. La tension sur le collecteur de ce transistor, qui est la tension d'alimentation VCC, est bien supérieure à la tension sur la base et le transistor Q4 ne fonctionne pas en régime de saturation.

Il a également été vu précédemment que la tension sur le collecteur C5 du transistor Q5 est de l'ordre de VBE quand ce transistor est passant. La chute de tension entre la base et le collecteur est pratiquement nulle et le transistor Q5 ne fonctionne pas en régime de saturation.

La résistance R2 est peu élevée, de l'ordre de quelques milliers d'ohms. Lorsque l'entrée A1 passe de l'état haut à l'état bas, la capacité base-collecteur du transistor Q1 est chargée avec un courant de charge important, et la charge de la capacité n'est pas critique. En outre, la résistance R1 a une valeur très faible, de l'ordre de 50 ohms. Le gain en tension du transistor Q1 est limité. Ce transistor Q1 présente un effet Miller très faible à la fermeture.

On a ainsi montré que, dans chacun des états du circuit, aucun des transistors à l'état passant ne fonctionne en régime de saturation et qu'aucun des transistors à l'état bloqué ne présentera d'effet Miller important à la fermeture. La vitesse de commutation de ce circuit pourra donc être élevée (de l'ordre de une à deux nanosecondes).

On notera que le circuit selon l'invention peut être considéré comme constitué de deux étages inverseurs. Jusqu'à présent, il était couramment pressenti que, dans un tel cas, chacun des deux inverseurs devait être compatible TTL. Dans le circuit de la figure 2, la sortie de l'inverseur constituant l'étage intermédiaire 11 est formée par le collecteur C5 du transistor Q5. On a vu que la tension sur le collecteur de ce transistor Q5 est de l'ordre de VBE lorsque le transistor est passant, ce qui permet d'éviter le fonctionnement en régime de saturation. La tension de sortie de l'inverseur est alors supérieure à la tension de compatibilité minimale des circuits TTL de 0,4 V, ce qui s'écarte du préjugé susmentionné généralement admis dans la technique.

Selon un aspect de l'invention, l'émetteur du transistor Q3 est relié à la masse par l'intermédiaire de deux résistances R4 et R3, alors que l'émetteur du transistor Q4 n'est relié à la masse que par l'intermédiaire d'une résistance R5. La présence de la résistance R4 entraîne le fait que lors du passage de l'état bas à l'état haut sur l'entrée A1, le transistor Q3 est mis en conduction après le transistor Q4. Cela présente l'avantage de rendre passant le transistor Q2 après la mise à l'état bloqué du transistor Q1, au lieu que cela soit réalisé simultanément. D'une manière similaire, lors du passage de l'état haut à l'état bas sur l'entrée, le transistor Q2 est mis à l'état bloqué avant la mise en conduction du transistor Q1. Ainsi, le transistor Q2 ne consomme pas de courant en provenance du transistor Q1 et la consommation du circuit est réduite lors des régimes transitoires.

Selon une première variante, les dimensions des transistors Q3, Q4 et Q5 sont telles que les tensions base-émetteur des transistors Q4 et Q5 à l'état passant sont inférieures à la tension base-émetteur du transistor Q3 à l'état passant. En effet, si l'on augmente les dimensions de l'émetteur d'un transistor bipolaire, la tension base-émetteur VBE de ce transistor à l'état passant diminue, et si l'on diminue les dimensions de l'émetteur, la tension VBE augmente. Ainsi, on augmente l'effet de décalage dans le temps entre les commutations des transistors Q1 et Q2 initialement dû à la présence de la résistance R4 (les dimensions du transistor Q2 sont fixées en fonction de l'intensité du courant reçu sur la sortie S à absorber). Il serait également possible d'adapter les dimensions des diodes D1, D2 et D3. La modification des dimensions des transistors et diodes concerne plus particulièrement les cas de signaux de commande sur l'entrée A1 à temps de montée ou de descente longs.

Selon une deuxième variante, le circuit peut comporter d'autres bornes d'entrées. Une deuxième entrée A2 est par exemple représentée sur la figure 2. Cette entrée A2 est connectée à la cathode 30 d'une diode D4-1 dont l'anode 31 est reliée à l'anode 15 de la diode D4. L'entrée A2 est aussi connectée à la cathode 32 d'une diode D5-1 dont l'anode 33 est reliée à l'anode 20 de la diode D5.

Selon une troisième variante, une capacité C est rajoutée aux bornes de la résistance R4 (en pointillés sur la figure 3). Lorsque l'entrée A1 passe de l'état bas à l'état haut, le courant IE3 dans l'émetteur du transistor Q3 se répartit dans la résistance R4 et dans la capacité C. En régime transitoire, il passe dans la capacité C un courant de charge di=CdV/dt. Ce courant s'ajoute au courant traversant la résistance R4. Ainsi, en raison de la présence de la capacité C, le courant dans la base du transistor Q2 est plus élevé en régime transitoire. Le transistor Q2 peut absorber plus rapidement le courant reçu sur la sortie S.

**Revendications**

1. Circuit de sortie compatible avec des circuits du type TTL, ayant une borne de sortie (S) et une borne d'entrée (A1), réalisé sans dispositifs Schottky, comprenant un étage intermédiaire (11) et un étage de sortie (12) reliés à une source d'alimentation dont la première borne (13) délivre une tension supérieure à celle de sa deuxième borne (14), dans lequel l'étage de sortie comprend :
   - un premier transistor (Q1) dont le collecteur (C1) et la base (B1) sont reliés à la première borne de la source d'alimentation par l'intermédiaire d'une première résistance (R1) et d'une deuxième résistance (R2), respectivement,
   - une première diode (D1) dont l'anode (9) est reliée à l'émetteur (E1) du premier transistor et dont la cathode (10) est reliée à la borne de sortie,
   - un deuxième transistor (Q2) dont le collecteur (C2) est relié à la borne de sortie, dont l'émetteur (E2) est connecté à la deuxième borne de la source d'alimentation et dont la base (B2) est reliée à une troisième résistance (R3) dont la borne libre est connectée à la deuxième borne de la source d'alimentation,
   - un troisième transistor (Q3), dont l'émetteur (E3) est connecté à la base du deuxième transistor par l'intermédiaire d'une quatrième résistance (R4), dont le collecteur (C3) est connecté à la première borne de la source d'alimentation et dont la base (B3) est reliée à la borne d'entrée,
   - une deuxième diode (D2) dont l'anode (17) est reliée à la borne d'entrée et dont la cathode (18) est connectée à l'émetteur du premier transistor,
   caractérisé en ce que l'étage intermédiaire (11) est constitué par un inverseur qui comprend :
   - un quatrième transistor (Q4) dont le collecteur (C4) est connecté à la première borne (13) de la source d'alimentation, dont l'émetteur (E4) est relié par l'intermédiaire d'une cinquième résistance (R5) à la deuxième borne (14) de la source d'alimentation et dont la base (B4) est reliée à la borne d'entrée (A1),
   - un cinquième transistor (Q5) dont la base (B5) est connectée à l'émetteur du quatrième transistor, dont l'émetteur (E5) est connecté à la deuxième borne de la source d'alimentation et dont le collecteur (C5) est connecté à la base (B1) du premier transistor (Q1), et
   - une troisième diode (D3) dont l'anode (22) est reliée à la borne d'entrée et dont la cathode (23) est connectée au collecteur du cinquième transistor.

2. Circuit de sortie selon la revendication 1, caractérisé en ce que la tension de sortie de l'inverseur est toujours supérieure à la tension de compatibilité minimale des circuits TTL.

3. Circuit de sortie selon la revendication 1, caractérisé en ce que l'étage de sortie (12) comprend en autre une quatrième diode (D4) dont l'anode (15) est connectée à la base (B3) du troisième transistor (Q3) et la cathode (16) est connectée à la borne d'entrée (A1), et en ce que l'inverseur comprend en outre une cinquième diode (D5) dont l'anode (20) est connectée à la base (B4) du quatrième transistor (Q4) et la cathode (21) est connectée à la borne d'entrée (A1).

4. Circuit de sortie selon la revendication 3, caractérisé en ce qu'il comprend au moins une première borne d'entrée (A1) et une deuxième borne d'entrée (A2), la deuxième borne d'entrée (A2) étant connectée d'une part à la cathode (30) d'une sixième diode (D4-1) dont l'anode (31) est connectée à l'anode (15) de la quatrième diode (D4) et d'autre part à la cathode (32) d'une septième diode (D5-1) dont l'anode (33) est connectée à l'anode (20) de la cinquième diode (D5).

5. Circuit de sortie selon la revendication 1, caractérisé en ce qu'une capacité (C) est rajoutée aux bornes de la quatrième résistance (R4).

6. Circuit de sortie selon la revendication 1, caractérisé en ce que les dimensions des troisiéme, quatrième et cinquième transistors (Q3, Q4, Q5) sont telles que les tensions base-émetteur des quatrième et cinquième transistors (Q4, Q5) à l'état passant sont inférieures à la tension base-émetteur du troisième transistor (Q3) à l'état passant.

**Claims**

1. Mit TTL-Schaltkreisen kompatible Ausgangsschaltung, mit einem Ausgangsanschluß (S) und einem Eingangsanschluß (A1), die ohne Schottky-Vorrichtungen realisiert ist, mit einer Zwischenstufe (11) und einer Ausgangsstufe (12), welche mit einer Versorgungsquelle verbunden sind, deren erster Anschluß (13) eine Spannung liefert, die höher ist als die Spannung ihres zweiten Anschlusses (14), wobei die Ausgangsstufe folgende Merkmale aufweist:
   - einen ersten Transistor (Q1), dessen Kollektor (C1) und dessen Basis (B1) mit dem ersten Anschluß der Versorgungsquelle über einen ersten Widerstand (R1) bzw. einen zweiten Widerstand (R2) verbunden sind,
   - eine erste Diode (D1), deren Anode (9) mit dem Emitter (E1) des ersten Transistors verbunden ist und deren Kathode (10) mit dem Ausgangsanschluß verbunden ist,
   - einen zweiten Transistor (Q2), dessen Kollektor (C2) mit dem Ausgangsanschluß verbunden ist, dessen Emitter (E2) mit dem zweiten Anschluß der Versorgungsquelle verbunden ist und dessen Basis (B2) mit einem dritten Widerstand (R3) verbunden ist, dessen freier Anschluß mit dem zweiten Anschluß der Versorgungsquelle verbunden ist,
   - einen dritten Transistor (Q3), dessen Emitter (E3) mit der Basis des zweiten Transistors über einen vierten Widerstand (R4) verbunden ist, dessen Kollektor (C3) mit dem ersten Anschluß der Versorgungsquelle verbunden ist und dessen Basis mit dem Eingangsanschluß verbunden ist,
   - eine zweite Diode (D2), deren Anode (17) mit dem Eingangsanschluß verbunden ist und deren Kathode (18) mit dem Emitter des ersten Transistors verbunden ist,
dadurch gekennzeichnet, daß die zwischenstufe (11) aus einem Inverter besteht, der folgende Merkmale aufweist:
   - einen vierten Transistor (Q4), dessen Kollektor (C4) mit dem ersten Anschluß (13) der Versorgungsquelle verbunden ist, dessen Emitter (E4) über einen fünften Widerstand (R5) mit dem zweiten Anschluß (14) der Versorgungsquelle verbunden ist und dessen Basis (B4) mit dem Eingangsanschluß (A1) verbunden ist,
   - einen funften Transistor (Q5), dessen Basis (B5) mit dem Emitter des vierten Transistors verbunden ist, dessen Emitter (E5) mit dem zweiten Anschluß der Versorgungsquelle verbunden ist und dessen Kollektor (C5) mit der Basis (B1) des ersten Transistors (Q1) verbunden ist, und
   - eine dritte Diode (D3), deren Anode (22) mit dem Eingangsanschluß verbunden ist und deren Kathode (23) mit dem Kollektor des fünften Transistors verbunden ist.

2. Ausgangsschaltung nach Anspruch 1, dadurch gekennzeich net, daß die Ausgangsspannung des Inverters immer höher als die minimale Kompatibilitätsspannung der TTL-Schaltkreise ist.

3. Ausgangsschaltung nach Anspruch 1, dadurch gekennzeichnet, daß die Ausgangsstufe (12) ferner eine vierte Diode (D4) aufweist, deren Anode (15) mit der Basis (B3) des dritten Transistors (Q3) verbunden ist und deren Kathode (16) mit dem Eingangsanschluß (A1) verbunden ist, und daß der Inverter ferner eine funfte Diode (D5) aufweist, deren Anode (20) mit der Basis (B4) des vierten Transistors (Q4) verbunden ist und deren Kathode (21) mit dem Eingangsanschluß (A1) verbunden ist.

4. Ausgangsschaltung nach Anspruch 3, dadurch gekennzeichnet, daß sie mindestens einen ersten Eingangsanschluß (A1) und einen zweiten Eingangsanschluß (A2) aufweist, wobei der zweite Eingangsanschluß (A2) einerseits mit der Kathode (30) einer sechsten Diode (D4-1) verbunden ist, deren Anode (31) mit der Anode (15) der vierten Diode (D4) verbunden ist, und andererseits mit der Kathode (32) einer siebten Diode (D5-1) verbunden ist, deren Anode (33) mit der Anode (20) der fünften Diode (D5) verbunden ist.

5. Ausgangsschaltung nach Anspruch 1, dadurch gekennzeichnet, daß ein Kondensator (C) über den Anschlüssen des vierten Widerstandes (R4) hinzugefugt ist.

6. Ausgangsschaltung nach Anspruch 1, dadurch gekennzeichnet, daß die Größe des dritten, des vierten und des fünften Transistors (Q3, Q4, Q5) so bestimmt ist, daß die Basis-Emitter-Spannungen des vierten und des fünften Transistors (Q4, Q5) im leitenden Zustand niedriger sind als die Basis-Emitter-Spannung des dritten Transistors (Q3) im leitenden Zustand.

**Patentansprüche**

1. An output circuit compatible with TTL-type circuits, having an output terminal (S) and an input terminal (A1), manufactured without Schottky devices, comprising an intermediate stage (11) and an output stage (12) connected to a supply source, the first terminal (13) of which supplies a voltage higher than the voltage of its second terminal (14), wherein the output stage comprises:
   - a first transistor (Q1), the collector (C1) and base (B1) of which are connected to the first terminal of the supply source through a first resistor (R1) and a second resistor (R2), respectively,
   - a first diode (D1), the anode (9) of which is connected to the emitter (E1) of the first transistor and the cathode (10) is connected to the output terminal,
   - a second transistor (Q2), the collector (C2) of which is connected to the output terminal, the emitter (E2) of which is connected to the second terminal of the supply source and the base (B2) is connected to a third resistor (R3), the free terminal of which is connected to the second terminal of the supply source,
   - a third transistor (Q3), the emitter (E3) of which is connected to the base of the second transistor through a fourth resistor (R4), the collector (C3) of which is connected to the first terminal of the supply source and the base is connected to the input terminal,
   - a second diode (D2), the anode (17) of which is connected to the input terminal and the cathode (18) is connected to the emitter of the first transistor, characterized in that the intermediate stage (11) is comprised of an inverter which comprises:
   - a fourth transistor (Q4), the collector (C4) of which is connected to the first terminal (13) of the supply source, the emitter (E4) of which is connected through a fifth resistor (R5) to the second terminal (14) of the supply source and the base (B4) is connected to the input terminal (A1),
   - a fifth transistor (Q5), the base (B5) of which is connected to the emitter of the fourth transistor, the emitter (E5) of which is connected to the second terminal of the supply source and the collector (C5) is connected to the base (B1) of the first transistor (Q1), and
   - a third diode (D3), the anode (22) of which is connected to the input terminal and the cathode (23) is connected to the collector of the fifth transistor.

2. An output circuit according to claim 1, characterized in that the output voltage of the inverter is always higher than the minimum compatibility voltage of TTL circuits.

3. An output circuit according to claim 1, characterized in that the output stage (12) further comprises a fourth diode (D4), the anode (15) of which is connected to the base (B3) of the third transistor (Q3) and the cathode (16) is connected to the input terminal (A1) and in that the inverter further comprises a fifth diode (D5), the anode (20) of which is connected to the base (B4) of the fourth transistor (Q4) and the cathode (21) is connected to the input terminal (A1).

4. An output circuit according to claim 3, characterized in that it comprises at least a first input terminal (A1) and a second input terminal (A2), the second input terminal (A2) being connected on the one hand to the cathode (30) of a sixth diode (D4-1), the anode (31) of which is connected to the anode (15) of the fourth diode (D4) and on the other hand to the cathode (32) of a seventh diode (D5-1), the anode (33) of which is connected to the anode (20) of the fifth diode (D5).

5. An output circuit according to claim 1, characterized in that a capacitor (C) is added across the terminals of the fourth resistor (R4).

6. An output circuit according to claim 1, characterized in that the size of the third, fourth and fifth transistors (Q3, Q4, Q5) is such that the base-emitter voltages of the fourth and fifth transistors (Q4, Q5) in the conductive state are lower than the base-emitter voltage of the third transistor (Q3) in the conductive state.

Figure 1

Figure 2

EP 0 384 863 B1

EP 0 384 863 B1

Figure 3

11